# EUROPEAN PATENT SPECIFICATION

(11) **EP 2 778 261 B1**
(45) Date of publication and mention of the grant of the patent: **06.07.2016**
(21) Application number: 14159761.7
(22) Date of filing: 14.03.2014
(51) Int. Cl.: C25D 3/38, C25D 5/10, C25D 5/34, H05K 3/42, C25D 5/02, C23C 18/16

(54) **Method of filling through-holes**
Verfahren zum Füllen von Durchgangslöchern
Procédé de remplissage de trous traversants

(30) Priority: 14.03.2013 US 201313829433
(43) Date of publication of application: 17.09.2014
(73) Proprietor: Rohm and Haas Electronic Materials LLC, Marlborough, MA 01752 (US)
(72) Inventor: Jayaraju, Nagarajan, Framingham, MA Massachusetts 01702 (US); Najjar, Elie H., Norwood, MA Massachusetts 02062 (US); Barstad, Leon R., Raynham, MA Massachusetts 02767 (US)
(74) Representative: Hoggins, Mark Andrew

(56) References cited:
- EP-A1- 1 152 071
- EP-A2- 1 122 989
- EP-A2- 1 249 861
- EP-A2- 2 366 692
- US-A1- 2007 235 343
- US-A1- 2009 277 867

## Description

### Field of the Invention

The present invention is directed to a method of filling through-holes having a layer of flash copper which reduces or inhibits the formation of dimples and voids. More specifically, the present invention is directed to a method of filling through-holes having a layer of flash copper which reduces or inhibits the formation of dimples and voids by applying an aqueous acid pretreatment solution containing disulfide compounds at low concentrations to the through-holes with the flash copper layer followed by filling the through-holes with copper using an acid copper electroplating bath containing brighteners and levelers.

### Background of the Invention

High density interconnects is an important design in the fabrication of printed circuit boards with microvias and through-holes. Miniaturization of these devices relies on a combination of thinner core materials, reduced line widths and smaller diameter through-holes and blind vias. The diameters of the through-holes range from 75 µm to 200 µm. Filling the through-holes by copper plating has become more and more difficult with higher aspect ratios. This results in larger voids and deeper dimples. Another problem with through-hole filling is the way they tend to fill. Unlike vias which are closed at one end through-holes pass through a substrate and are open at two ends. Vias fill from bottom to top. In contrast, when through-holes are being filled with copper, the copper tends to begin to deposit on the walls at the center of the through-hole where it plugs at the center forming "butterfly wings" or two vias. The two vias fill to complete the deposition of the holes. Accordingly, the copper plating baths used to fill vias are not typically the same as are used to fill through-holes. Document EP 1122989 A2 describes a method for filling vias, wherein a disulfide compound is used in a pretreatment step to promote the deposition process in the via. Plating bath levelers and other bath additives are chosen to enable the right type of fill. If the right combination of additives is not chosen then the copper plating results in undesired conformal copper deposition. Document EP 2366692 A2 teaches a method wherein a disulfide compound is used as an accelerator agent in a plating bath to fill through-holes.

Often the copper fails to completely fill the through-hole and both ends remain unfilled. An incomplete through-hole fill with copper deposit in the center with unfilled ends is sometimes referred to as "dog-boning". The open spaces at the top and bottom of the holes are referred to as dimples. Entire dimple elimination during through-hole filling is rare and unpredictable. Dimple depth is perhaps the most commonly used metric for quantifying through-hole fill performance. Dimple requirements depend on through-hole diameter and thickness and it varies from one manufacturer to another. In addition to dimples, gaps or holes referred to as voids may form within a copper through-hole fill. Larger dimples affect further processing of the panel and larger voids affect device performance. An ideal process completely fills through-holes with a high degree of planarity, i.e., build up consistency, without voids to provide optimum reliability and electrical properties and at as low as possible a surface thickness for optimum line width and impedance control in an electrical device.

Another problem associated with through-hole filling is filling through-holes with electrolytic copper when the through-hole walls have a layer of flash copper. Typically substrates containing through-holes, such as printed circuit boards, are copper clad with a layer of electroless copper on a surface and on the walls of the through-holes. Electroless copper thickness is usually greater than 0.25µm. Such electroless copper layers tend to oxidize. Often printed circuit boards are electrolessly plated with copper and stored for a period of time prior to further processing. Prolonged periods of exposure to air as well as general handling of the boards result in relatively rapid oxidation of the electroless copper layer. To address this problem the industry electroplates a layer of flash copper 2µm to 5µm thick on the surface of the electroless copper prior to storage to protect the electroless copper from oxidation. Also, the thicker flash copper layer allows for removal of any oxide formation during storage by conventional etching processes whereas such etching cannot be done on the thinner electroless copper without the danger of damaging or removing the electroless copper layer. Unfortunately, electrolytic copper flash adds to the difficulty of filling through-holes. Dimpling and void formation frequently occur when workers try to fill through-holes using acid electrolytic copper plating baths.

Accordingly, there is a need for a method to improve through-hole filling in substrates which have a flash copper layer.

### Summary of the Invention

Methods include providing a substrate with a plurality of through-holes and a layer of copper flash on a layer of electroless copper plated on a surface of the substrate and walls of the plurality of through-holes; applying an aqueous acid solution to at least the plurality of through-holes, the aqueous acid solution comprising 50 ppb to 500 ppb of one or more disulfide compounds having a formula: 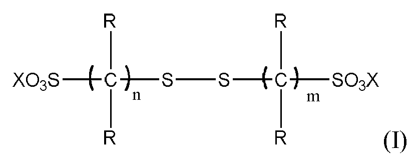 wherein X is sodium, potassium or hydrogen, R is independently hydrogen or an alkyl, n and m are integers of 1 or greater; and electroplating at least the through-holes with copper using an acid copper electroplating bath comprising one or more brighteners and one or more levelers.

The methods reduce or inhibit dimple formation and voids during through-hole filling. Dimples are typically less than 10µm deep. The reduced depth of the dimples and void area improves throwing power, thus provides a substantially uniform copper layer on the surface of the substrate and good through-hole filling.

### Detailed Description of the Invention

As used throughout this specification, the abbreviations given below have the following meanings, unless the context clearly indicates otherwise: g = gram; ml = milliliter; L = liter; cm = centimeter; mm = millimeter; µm = micron; ppm = parts per million; ppb = parts per billion; ° C = degrees Centigrade; g/L = grams per liter; A = amperes; dm = decimeters; DI = deionized; wt% = percent by weight; T_{g} = glass transition temperature; Void = a space free of copper within a through-hole otherwise filled with copper metal; aspect ratio of a through-hole = height of the through-hole/the diameter of the through-hole; dimple depth = distance from the deepest point of the dimple to the level of copper plated on the surface of a substrate; void area of a single through-hole = 0.5A x 0.5 B x π where A is height of the void and B is the diameter of the void at its widest point in a through-hole; through-hole area = height of the through-hole x the diameter of the through-hole; and %void area = void area/through-hole area x 100%.

### Summary of the Invention

The terms "printed circuit board" and "printed wiring board" are used interchangeably throughout this specification. The terms "plating" and "electroplating" are used interchangeably throughout this specification. The term "throwing power" means the ability to plate in low current density areas with the same thickness as in higher current density areas. All amounts are percent by weight, unless otherwise noted. All numerical ranges are inclusive and combinable in any order except where it is logical that such numerical ranges are 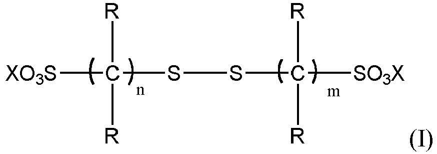 wherein X is sodium, potassium or hydrogen, preferably X is sodium or hydrogen; R is independently hydrogen or an alkyl, preferably R is independently hydrogen or (C₁-C₆)alkyl, more preferably R is independently hydrogen or (C₁-C₃)alky, most preferably R is hydrogen; n and m are integers of 1 or greater, preferably n and m are independently integers of 1 to 3, more preferably n and m are 2 or 3, most preferably n and m are 3. Preferably the disulfide compound is bis(3-sulfopropyl)disulfide or its sodium salt. Preferably the aqueous acid solution consists of water, one or more inorganic acids and one or more compounds having formula (I) above. Preferably the aqueous acid solution is free of any additional components.

The one or more disulfide compounds are included in the aqueous acid solution in amounts of 50 ppb to 500 ppb. The lower the concentration included in the acid solution the better because such disulfide compounds typically form breakdown products which may hinder uniform copper electroplating and through-hole filling. In addition, many copper electroplating baths used to fill through-holes include such disulfide compounds as brighteners or accelerators. The combination of the breakdown products in the copper electroplating bath and the acid solution may further increase the probability of poor through-hole filling. Accordingly, concentrations of the disulfide compounds in the ppb range are used.

Inorganic acids include, but are not limited to sulfuric acid, hydrochloric acid, nitric acid, hydrofluoric acid or phosphoric acid. Preferably the inorganic acid is sulfuric acid, hydrochloric acid or nitric acid, more preferably the acid is sulfuric acid or hydrochloric acid. Such acids may be included in the aqueous acid solutions in amounts of 0.5wt% to 20wt%, preferably 5wt% to 15wt%, more preferably from 8wt% to 12wt%. Typically the pH is 0 to 1, more typically less than 1.

The aqueous acid solutions may be applied to cleaned copper clad substrates with a plurality of through-holes by any suitable method, such as by immersing or dipping the substrate into the solution. The solution may be applied to the substrate by spraying it onto the substrate or by applying the solution with an atomizer using conventional apparatus. Temperatures may range from room temperature to 60° C, typically from room temperature to 40° C.

The substrates are plated with a layer of electroless copper such that the electroless copper is adjacent a surface of the substrate and the walls of the through-holes. The electroless copper may have a thickness, typically, from 0.25 µm to 6 µm, more typically from 0.25 µm to 3 µm. The electroless copper is plated with a layer of electrolytic flash copper to protect it from corrosion. The thickness of the electroplated flash copper adjacent the electroless copper layer ranges from 0.5 µm to 15 µm, typically from 1 µm to 10 µm, more typically from 1 µm to 5 µm.

The through-holes of the substrate typically range in diameter from 75µm to 200µm. The through-holes traverse the width of the substrates and are typically 100 µm to 400 µm.

Substrates include printed circuit boards which may contain thermosetting resins, thermoplastic resins and combinations thereof, including fiber, such as fiberglass, and impregnated embodiments of the foregoing.

Thermoplastic resins include, but are not limited to acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

The printed wiring boards may include low or high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to, polytetrafluoroethylene (PTFE) and polytetrafluoroethylene blends. Such blends include, for example, PTFE with polypheneylene oxides and cyanate esters. Other classes of polymer resins which include resins with a high T_{g} include, but are not limited to, epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polypheneylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

The dwell time for the solution on the substrate may range from 0.5 to 5 minutes, preferably from 0.5 minutes to 3 minutes, more preferably from 0.5 to 2 minutes. The treated substrate is then electroplated with copper using an acid copper electroplating bath to fill the through-holes. In addition to one or more sources of copper ions and one or more acids, the acid copper electroplating bath also includes at least one or more brighteners and one or more levelers.

Sources of copper ions include, but are not limited to water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper hydroxide and copper sulfamate. Conventional amounts of copper salts may be used in the compositions. Copper salts are included in the bath in amounts of 50 g/l to 350 g/L, typically 100 g/L to 250 g/L.

Acids include, but are not limited to sulfuric acid, hydrochloric acid, hydrofluoric acid, phosphoric acid, nitric acid, sulfamic acid and alkylsulfonic acids. Such acids are included in conventional amounts. Typically such acids are included in the acid copper baths in amounts of 25 g/l to 350 g/L.

Brighteners include, but are not limited to 3-mercapto-propylsulfonic acid and its sodium salt, 2-mercapto-ethanesulfonic acid and its sodium salt, and bissulfopropyl disulfide and its sodium salt, 3-(benzthiazoyl-2-thio)-propylsulfonic acid sodium salt, 3-mercaptopropane-1-sulfonic acid sodium salt, ethylenedithiodipropylsulfonic acid sodium salt, bis-(p-sulfophenyl)-disulfide disodium salt, bis-(ω-sulfobutyl)-disulfide disodium salt, bis-(ω-sulfohydroxypropyl)-disulfide disodium salt, bis-(ω-sulfopropyl)-disulfide disodium salt, bis-(ω-sulfopropyl)-sulfide disodium salt, methyl-(ω-sulfopropyl)-disulfide sodium salt, methyl-(ω-sulfopropyl)-trisulfide disodium salt, O-ethyl-dithiocarbonic acid-S-(ω-sulfopropyl)-ester, potassium salt thioglycoli acid, thiophosphoric acid-O-ethyl-bis-(ω)-sulfpropyl)-ester disodium salt, thiophosphoric, acid-tris(ω-sulfopropyl)-ester trisodium salt, N,N-dimethyldithiocarbamic acid (3-sulfopropyl) ester, sodium salt, (O-ethyldithiocarbonato)-S-(3-sulfopropyl)-ester, potassium salt, 3-[(amino-iminomethyl)-thio]-1-propanesulfonic acid and 3-(2-benzthiazolylthio)-1-propanesulfonic acid, sodium salt. Preferably the brightener is bissulfopropyl disulfide or its sodium salt. Typically the brighteners are included in amounts of 1 ppb to 500 ppm, preferably from 50 ppb to 10 ppm.

Levelers included in the conformal acid copper electroplating baths are typically reaction products of heterocyclic aromatic compounds with epoxy compounds. Synthesis of such compounds is disclosed in the literature such as in U.S. 8,268,158. Preferably the levelers are reaction products of at least one imidazole compound of the formula: 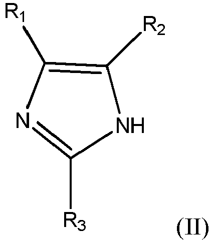 wherein R₁, R₂ and R₃ are independently chosen from H, (C₁-C₁₂)alkyl, (C₂-C₁₂)alkenyl, and aryl and provided that R₁ and R₂ are not both H. That is, the reaction products contain at least one imidazole wherein at least one of R₁ and R₂ is (C₁-C₁₂)alkyl, (C₂-C₁₂)alkenyl, or aryl. Such imidazole compound is substituted with a (C₁₋C₁₂)alkyl, (C₂-C₁₂)alkenyl, or aryl at the 4- and/or 5-position. Preferably, R₁, R₂ and R₃ are independently chosen from H, (C₁-C₈)alkyl, (C₂-C₇)alkenyl and aryl, more preferably H, (C₁-C₆)alkyl, (C₃-C₇)alkenyl and aryl, and even more preferably H, (C₁-C₄)alkyl, (C₃-C₆)alkenyl and aryl. The (C₁-C₁₂)alkyl groups and the (C₂-C₁₂)alkenyl groups may each optionally be substituted with one or more of hydroxyl groups, halogen, and aryl groups. Preferably, the substituted (C₁-C₁₂)alkyl group is an aryl-substituted (C₁-C₁₂)alkyl group, and more preferably is (C₁-C₄)alkyl. Exemplary are (C₁-C₄)alkyl groups include, without limitation, benzyl, phenethyl, and methylnaphthyl. Alternatively, each of the (C₁-C₁₂)alkyl groups and the (C₂-C₁₂)alkenyl groups may contain a cyclic alkyl or cyclic alkenyl group, respectively, fused with an aryl group. As used herein, the term "aryl" refers to any organic radical derived from an aromatic or heteroaromatic moiety by the removal of a hydrogen atom. Preferably, the aryl group contains 6-12 carbon atoms. The aryl group in the present invention may optionally be substituted with one or more of (C₁-C₄)alkyl and hydroxyl. Exemplary aryl groups include, without limitation, phenyl, tolyl, xylyl, hydroxytolyl, phenolyl, naphthyl, furanyl, and thiophenyl. The aryl group is preferably phenyl, xylyl or naphthyl. Exemplary (C₁-C₁₂)alkyl groups and substituted (C₁-C₁₂)alkyl groups include, without limitation, methyl, ethyl, n-propyl, iso-propyl, n-butyl, iso-butyl, sec-butyl, n-pentyl, 2-pentyl, 3-pentyl, 2-(2-methyl)butyl, 2-(2,3-dimethyl)butyl, 2-(2-methyl)pentyl, neopentyl, hydroxymethyl, hydroxyethyl, hydroxypropyl, cyclopentyl, hydroxcyclopentyl, cyclopentylmethyl, cyclopentylethyl, cyclohexyl, cyclohexylmethyl, hydroxyclohexyl, benzyl, phenethyl, naphthylmethyl, tetrahydronaphthalenyl and tetrahydronaphthylmethyl. Exemplary (C₂-C₈)alkenyl groups include, but are not limited to allyl, styrenyl, cyclopentenyl, cyclopentylmethyl, cyclopentenylethyl, cyclohexenyl, cyclohexenylmethyl and indenyl. Preferably, the at least one imidazole compound is substituted with a (C₁-C₈)alkyl, (C₃-C₇)alkenyl, or aryl at the 4- or 5-position. More preferably, the at least one imidazole is substituted with (C₁-C₆)alkyl, (C₃-C₇)alkenyl, or aryl at the 4- or 5-position. Still more preferably, at least one imidazole is substituted at the 4- or 5-position with methyl, ethyl, propyl, butyl, allyl or aryl. The imidazole compounds are generally commercially available from a variety of sources, such as Sigma-Aldrich (St. Louis, Missouri) or may be prepared from literature methods.

One or more of the above described imidazole compounds are reacted with one or more epoxy compounds having formula: 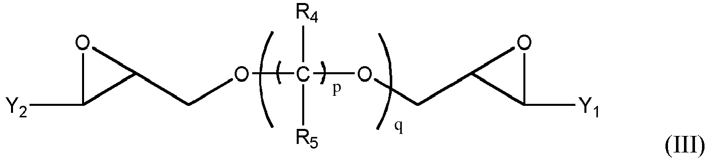 where Y₁ and Y₂ are independently chosen from hydrogen and (C₁-C₄)alkyl, R₄ and R₅ are independently chosen from hydrogen, CH₃ and OH, p = 1-6 and q = 1-20. Preferably, Y₁ and Y₂ are both H. When p = 2, it is preferred that each R₄ is H, R₅ is chosen from H and CH₃, and q = 1-10. When p = 3, it is preferred that at least one R₅ is chosen from CH₃ and OH, and q = 1. When p = 4, it is preferred that both R₄ and R₅ are H, and q = 1. Exemplary compounds of formula (III) include, but are not limited to: 1,4-butanediol diglycidyl ether, ethylene glycol diglycidyl ether, di(ethylene glycol) diglycidyl ether, poly(ethylene glycol) diglycidyl ether compounds, glycerol diglycidyl ether, neopentyl glycol diglycidyl ether, propylene glycol diglycidyl ether, di(propylene glycol) diglycidyl ether, and poly(propylene glycol) diglycidyl ether compounds. Poly(ethylene glycol) diglycidyl ether compounds of formula III are those compounds where each of R₄ and R₅ = H, p = 2, and q = 3-20, and preferably q = 3-15, more preferably q = 3-12, and still more preferably q = 3-10. Exemplary poly(ethylene glycol) diglycidyl ether compounds include tri(ethylene glycol) diglycidyl ether, tetra(ethylene glycol) diglycidyl ether, penta(ethylene glycol) diglycidyl ether, hexa(ethylene glycol) diglycidyl ether, nona(ethylene glycol) diglycidyl ether, deca(ethylene glycol) diglycidyl ether, and dodeca(ethylene glycol) diglycidyl ether. Poly(propylene glycol) diglycidyl ether compounds of formula III are those compounds where each of R₄ = H and one of R₅ = CH₃, p = 2, and q = 3-20, and preferably q = 3-15, more preferably q = 3-12, and still more preferably q = 3-10. Exemplary poly(propylene glycol) diglycidyl ether compounds include tri(propylene glycol) diglycidyl ether, tetra(propylene glycol) diglycidyl ether, penta(propylene glycol) diglycidyl ether, hexa(propylene glycol) diglycidyl ether, nona(propylene glycol) diglycidyl ether, deca(propylene glycol) diglycidyl ether, and dodeca(propylene glycol) diglycidyl ether. Suitable poly(ethylene glycol) diglycidyl ether compounds and poly(propylene glycol) diglycidyl ether compounds are those having a number average molecular weight of from 350 to 10000, and preferably from 380 to 8000.

Other additives which may be included in the copper electroplating baths are one or more complexing agents, one or more sources of chloride ions, stabilizers such as those which adjust mechanical properties, provide rate control, refine grain structure and modify deposit stress, buffering agents, suppressors and carriers. They may be included in the conformal copper electroplating bath in conventional amounts.

Through-hole filling is typically done at current densities of 0.5 A/dm² to 5 A/dm², preferably from 1 A/dm² to 3 A/dm². The plating bath temperature may range from room temperature to 60° C, typically from room temperature to 40° C. Electroplating is done until the through-holes are filled with minimum copper on the surfaces to make it easier for post treatment and prepare the substrate for further processing.

The methods reduce or inhibit dimple formation and voids during through-hole filling. The void area as well as the %void area of through-holes is reduced or eliminated. Dimple formation is 10 µm or less, typically dimple size is less than 10 µm with no voids in the through-holes which is the preferred industry standard. The reduced depth of the dimples and voids improves throwing power, thus provides a substantially uniform copper layer on the surface of the substrate.

The following examples are included to further illustrate the invention but are not intended to limit its scope.

### Example 1 (Comparative)

Two FR4/glass-epoxy coupons 5 cm wide, 15 cm long and 100 µm thick with a plurality of through-holes were provided by Tech Circuit. The through-holes had an average diameter of 100 µm. The coupons contained a layer of electroless copper on one side and on the walls of the through-holes. The thickness of the copper layer on each coupon was 0.3µm. The two coupons were pre-cleaned using a conventional copper cleaner. One coupon was placed into a dessicator. The other coupon was then placed in a plating cell which contained a copper electroplating bath with a formula as shown in Table 1.

**Table 1**

| **COMPONENT** | **AMOUNT** |
|---|---|
| Copper sulfate pentahydrate | 220 g/L |
| Sulfuric acid | 40 g/L |
| Chloride ion from hydrochloric acid | 50 ppm |
| Polyethylene glycol | 2 g/L |
| 4-phenylimidazole/imidazole/1,4-butandiol diglycidyl ether copolymer | 50 mg/L |
| Bis-sodium sulfopropyl)-disulfide | 10 mg/L |

The coupon was connected to a conventional DC rectifier. The counter electrode in each plating cell was an insoluble. The plating bath was air agitated during electroplating. The current density was set at 1 A/dm². Copper electroplating was done for 20 minutes at room temperature to deposit a flash copper layer on the electroless copper layer on the surface and walls of the through-holes of 5µm. The coupon with the flash copper was then placed in the dessicator with the other coupon which included only the electroless copper layer for storage for the interim prior to further treatment and electroplating to discourage oxide formation on the copper.

Each coupon was removed from the dessicator and cleaned using a conventional copper cleaner. Each coupon was then placed into separate plating cells containing the copper electroplating bath of Table 1. The counter electrode was an insoluble anode. Copper electroplating was done at a current density of 1.5 A/dm² for 82 minutes with continuous air agitation of the bath at room temperature. After electroplating the coupons were removed from the plating cells, rinsed with DI water and sectioned for an analysis of copper layer uniformity and through-hole filling. The sectioned samples were examined using a conventional optical microscope. Good plug and fill with an average dimple depth of 4.3µm and an average void area of 10% was observed on the coupon which was only electrolessly plated with copper. The coupon having the flash copper had through-holes without plug and fill or the through-holes were only partially filled.

### Example 2 (Comparative)

Three FR4/glass-epoxy coupons 5 cm wide, 15 cm long and 100 µm thick with a plurality of through-holes were provided by Tech Circuit. The through-holes had an average diameter of 100 µm. The coupons were processed through electro less copper using CIRCUPOSIT™ 880 Electroless Process plating formulations and method. The thickness of the electroless copper layer on each coupon was 0.3 µm. Each coupon was cleaned and electroplated with a flash copper layer 5 µm thick as described in Example 1 above. Each coupon was then placed in a dessicator during the interim before further processing to discourage any oxide formation on the copper.

Upon removal of the coupons from the dessicator, they were cleaned using a conventional copper cleaner to remove any possible oxide layer and have a clean copper surface for plating. Each coupon was then placed into separate plating cells with a fresh copper electroplating bath having the formulation in Table 1. The plating baths were air agitated during electroplating. One coupon was plated at 1.5 A/dm², the second at 2.2 A/dm² and the third was plated at 3 A/dm² for 82 minutes, 63 minutes and 41 minutes, respectively. Plating was done at room temperature. After electroplating the coupons were removed from their plating cells, rinsed with DI water and allowed to air dry. Each was then sectioned and examined under an optical microscope for an analysis of through-hole filling. None of the through-holes in any of the sections examined were completely filled. Filling was irregular. Large dimples in excess of 10 µm were observed in the through-holes which appeared to be more than 50% filled. Most of the through-holes which had some filling showed extensive dog-boning in the through-hole centers; however, most of the through-holes examined were not filled. The variation in the current density did not appear to affect through-hole filling.

### Example 3 (Comparative)

Three FR4/glass-epoxy coupons 5 cm wide, 15 cm long and 100 µm thick with a plurality of through-holes were provided by Tech Circuit. The through-holes had an average diameter of 100 µm. The coupons had a layer of electroless copper 0.3µm thick. Each coupon was cleaned and electroplated with a flash copper layer 5 µm thick as described in Example 1 above. The coupons were stored in a dessicator prior to further treatment and plating.

Upon removal from storage, the flashed coupons were cleaned to remove any oxide layer and have a clean copper surface for plating. After cleaning, one coupon was transferred to a plating bath having the formula of Table 1. The second coupon was first immersed in an aqueous solution of 5.5 ppm bis(3-sulfopropyl)disulfide, sodium salt (SPS) and 10wt% sulfuric acid for two minutes and then transferred into the copper electroplating bath. Copper electroplating was done at a current density of 1.5 A/dm² with continuous air agitation of the bath for 82 minutes. Plating was done at room temperature. After electroplating the coupons were removed from the plating cells, rinsed with DI water and sectioned for an analysis of copper layer uniformity and through-hole filling. The sectioned samples were examined under an optical microscope. No plug or partially filled holes were seen on the flash copper coupon which was not treated with the aqueous acid solution containing SPS. However, superior through-hole fill with an average dimple depth of 3.6µm and an average void area of 6.3% was achieved on the flash coupon which was immersed in the acid solution containing SPS.

### Example 4 (Comparative)

Six FR4/glass-epoxy coupons 5 cm wide, 15 cm long and 100 µm thick with a plurality of through-holes were provided. The through-holes had an average diameter of 100 µm. The coupons contained a layer of electroless copper on a surface and on the walls of the through-holes. The thickness of the copper layer was 0.3 µm. Each coupon was electroplated with a flash copper layer. Five electroless copper coupons were flashed with copper of different thickness of 1 µm, 2 µm, 3 µm, 4 µm and 5 µm and the sixth coupon was flashed with 5 µm. The copper electroplating bath and plating method were as described in Example 1 above. The coupons were all placed in a dessicator in the interim prior to any further processing.

Upon removal of the flashed coupons from the dessicator, each was cleaned to remove any oxide and have a clean copper surface for plating. Coupons 1-5 were transferred into a plating bath having the formulation as shown in Table 1 above. The sixth coupon was first immersed in an aqueous solution of 5.5 ppm bis(3-sulfopropyl)disulfide, sodium salt (SPS) and 10wt% sulfuric acid for two minute and then transferred into the copper electroplating bath. Copper electroplating was done at a current density of 1.5 A/dm² with continuous air agitation of the bath for 82 minutes. Plating was done at room temperature. After electroplating the coupons were removed from the plating cells, rinsed with DI water and sectioned for an analysis of copper layer uniformity and through-hole filling. The sectioned samples were examined under an optical microscope. No plug or partially filled holes were seen on the flash copper coupons 1-5. The through-holes of the sixth coupon which was treated in the acid solution with SPS had an average dimple depth of 3.63 gm and an average void are of 6.1%. Superior results were achieved with the coupon immersed in the SPS acid solution prior to through-hole filling.

### Example 5 (Comparative)

Eight FR4/glass-epoxy coupons 5 cm wide, 15 cm long and 100 µm thick with a plurality of through-holes were provided. The through-holes had an average diameter of 100 µm. The coupons had an electroless copper layer 0.3 µm thick. Each coupon was cleaned then electroplated with a flash copper layer 5 µm thick as described in Example 1 above. The coupons were stored in a dessicator during the interim between flash copper plating and further processing.

Upon removal of the coupons from the dessicator, they were cleaned then each coupon was immersed in separate aqueous solutions of SPS and 10wt% sulfuric acid for two minutes. The SPS concentration of each solution varied as shown in Table 2 below.

After two minutes the coupons were removed from the solutions then placed in plating cells containing a copper electroplating bath as described in Table 1 above. The coupons were electroplated with copper for 82 minutes with air agitation to a surface thickness of 25 µm. The current density was maintained at 1.5 A/dm². The plating was done at room temperature. After copper plating was completed the coupons were removed from the plating cells, rinsed with DI water and allowed to air dry at room temperature. Each coupon was then sectioned to examine the dimple height and voids of the through-holes. The dimple depth was measured using an optical microscope. The dimple depth was the distance from the deepest part of the dimple to the level of the copper layer on the surface of the coupon as measured in microns. The area of a particular void was determined using the formula: void area = 0.5A x 0.5B x π where A is the height of the void and B is the diameter of the void at its widest point. The formula used to determine % void area = void area/hole area x 100% where hole area is height of the through-hole without any copper flash layer x the diameter of the through-hole. The results are in Table 2 below.

**Table 2**

| **SAMPLE** | **SPS ppm** | **DIMPLE HEIGHT µm** | **VOID%** |
|---|---|---|---|
| 1 | 2 | 0.3 | 0 |
| 2 | 2.75 | 2.7 | 2.2 |
| 3 | 5.5 | 3.63 | 6.1 |
| 4 | 11 | 1.63 | 5.4 |
| 5 | 25 | 11.1 | 1.8 |
| 6 | 50 | 34.5 | 1.4 |
| 7 | 500 | 60.1 | 0 |
| 8 | 1000 | 67.2 | 0 |

Samples 1-4 had acceptable dimple depth below 10 µm. Although sample 4 had an average dimple depth of 1.63 µm which was lower than the dimple depth of samples 2-3, the overall results showed that as the concentration of SPS increased the dimple increased. Accordingly, as the concentration increased you began to lose fill performance. At high concentrations such as 500 ppm you completely lose fill performance. Although none of the through-holes examined in samples 7 and 8 had any observable voids, as the concentration of SPS declined from 5.5 ppm in sample 3 to 1 ppm in sample 1, the void area of the through-holes decreased. Accordingly, as the concentration of the SPS in the acid solution decreased there was a trend for decreased dimple depth and reduction in void area in the through-holes.

### Example 6

Two FR4/glass-epoxy coupons 5 cm wide, 15 cm long and 100 µm thick with a plurality of through-holes were provided. The through-holes had an average diameter of 100 µm. The coupons included a layer of electroless copper 0.3µm thick. Each coupon was cleaned and then electroplated with a flash copper layer 5 µm thick as described in Example 1 above. The coupons were then placed in a dessicator prior to any further processing.

Upon removing the coupons from the dessicator, each was cleaned then immersed in separate aqueous solutions of SPS and 10wt% sulfuric acid for two minutes. The SPS concentration of each solution varied as shown in Table 3 below. After two minutes the coupons were removed from the solutions and then placed in plating cells containing a copper electroplating bath as described in Table 1. The coupons were electroplated with copper over 82 minutes to a surface thickness of 25 µm with air agitation. The current density was maintained at 1.5 A/dm². Plating was done at room temperature. After copper plating was completed the coupons were removed from the plating cells, rinsed with DI water and allowed to air dry at room temperature. Each coupon was then sectioned to examine the dimple depth and void area of the through-holes. The results are in Table 3 below.

**Table 3**

| **SAMPLE** | **SPS ppb** | **DIMPLE HEIGHT µm** | **VOID %** |
|---|---|---|---|
| 1 | 100 | 4.2 | 0 |
| 2 | 500 | 0.9 | 0.1 |

Samples 1-2 had dimples well below 10 µm with an average void area of 0% in sample 1 and only 0.1% in sample 2. Even at very low concentrations in the ppb range SPS effectively reduced dimple depth and voids in copper electroplated through-holes.

## Claims

1. A method comprising:
a) providing a substrate with a plurality of through-holes and a layer of copper flash on a layer of electroless copper plated on a surface of the substrate and walls of the plurality of through-holes;
b) applying an aqueous acid solution to at least the plurality of through-holes, the aqueous acid solution comprising 50 ppb to 500 ppb of one or more disulfide compounds having a formula: 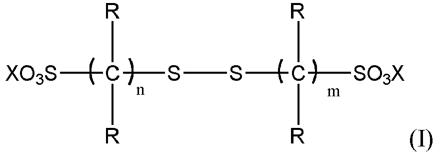 wherein X is sodium, potassium or hydrogen, R is independently hydrogen or an alkyl, n and m are integers of 1 or greater; and
c) electroplating at least the through-holes with copper using an acid copper electroplating bath comprising one or more brighteners and one or more levelers.

2. The method of claim 1, wherein X is sodium or hydrogen.

3. The method of claim 1, wherein R is independently hydrogen or (C₁-C₆)alkyl.

4. The method of claim 1, wherein m and n are independently integers of 1-6.

5. The method of claim 1, wherein the disulfide compound is bis(3-sulfopropyl) disulfide.

6. The method of claim 1, wherein the one or more levelers of the copper electroplating bath are reaction products of one or more imidazole compounds and one or more epoxy compounds.

## Patentansprüche

1. Ein Verfahren, das Folgendes beinhaltet:
a) Bereitstellen eines Substrats mit einer Vielzahl von Durchgangslöchern und einer Schicht aus Anschlagverkupferung auf einer Schicht aus stromlosem Kupfer, mit der eine Oberfläche des Substrats und Wände der Vielzahl von Durchgangslöchern überzogen sind;
b) Aufbringen einer wässrigen Säurelösung auf mindestens die Vielzahl von Durchgangslöchern, wobei die wässrige Säurelösung zu 50 ppb bis 500 ppb eine oder mehrere Disulfidverbindungen mit einer Formel wie folgt beinhaltet: 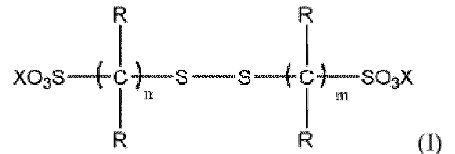 wobei X Natrium, Kalium oder Wasserstoff ist, R unabhängig Wasserstoff oder ein Alkyl ist, n und m ganze Zahlen von 1 oder größer sind; und
c) Galvanisieren mindestens der Durchgangslöcher mit Kupfer unter Verwendung eines Säure-Kupfer-Galvanisierbads, das einen oder mehrere Glanzbildner und einen oder mehrere Nivellierer beinhaltet.

2. Verfahren gemäß Anspruch 1, wobei X Natrium oder Wasserstoff ist.

3. Verfahren gemäß Anspruch 1, wobei R unabhängig Wasserstoff oder (C₁-C₆)Alkyl ist.

4. Verfahren gemäß Anspruch 1, wobei m und n unabhängig ganze Zahlen von 1 bis 6 sind.

5. Verfahren gemäß Anspruch 1, wobei die Disulfidverbindung Bis(3-sulfopropyl)disulfid ist.

6. Verfahren gemäß Anspruch 1, wobei der eine oder die mehreren Nivellierer des Kupfer-Galvanisierbads Reaktionsprodukte einer oder mehrerer Imidazolverbindungen und einer oder mehrerer Epoxidverbindungen ist/sind.

## Revendications

1. Une méthode comprenant :
a) le fait de fournir à un substrat une pluralité de trous traversants et une couche de précuivrage léger sur une couche de cuivre non-électrolytique plaquée sur une surface du substrat et des parois de la pluralité de trous traversants ;
b) le fait d'appliquer une solution acide aqueuse sur au moins la pluralité de trous traversants, la solution acide aqueuse comprenant de 50 ppb à 500 ppb d'un ou de plusieurs composés de disulfure ayant une formule : 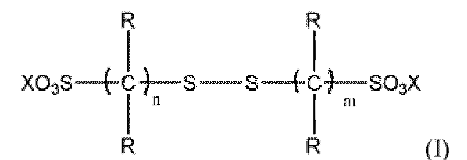 dans laquelle X est du sodium, du potassium ou de l'hydrogène, R est indépendamment de l'hydrogène ou un alkyle, n et m sont des nombres entiers de 1 ou plus ; et
c) le fait de galvaniser au moins les trous traversants avec du cuivre en utilisant un bain galvanique de cuivre acide comprenant un ou plusieurs brillanteurs et un ou plusieurs lisseurs.

2. La méthode de la revendication 1, dans laquelle X est du sodium ou de l'hydrogène.

3. La méthode de la revendication 1, dans laquelle R est indépendamment de l'hydrogène ou un alkyle en (C₁ à C₆).

4. La méthode de la revendication 1, dans laquelle m et n sont indépendamment des nombres entiers de 1 à 6.

5. La méthode de la revendication 1, dans laquelle le composé disulfure est le disulfure de bis(3-sulfopropyl).

6. La méthode de la revendication 1, dans laquelle ces un ou plusieurs lisseurs du bain galvanique de cuivre sont des produits de réaction d'un ou de plusieurs composés imidazole et d'un ou de plusieurs composés époxy.
